# EUROPEAN PATENT APPLICATION

(11) **EP 4 131 367 A1**
(43) Date of publication of application: **08.02.2023**
(21) Application number: 21189055.3
(22) Date of filing: 02.08.2021
(51) Int. Cl.: H01L 23/367, H01L 23/38, H01L 23/427, H01L 23/34

(54) **APPARATUS FOR COOLING**

(71) Applicant: Nokia Technologies Oy, 02610 Espoo (FI)
(72) Inventor: AMALFI, Raffaele Luca, New Providence, 07974 (US); GRILLANDA, Stefano, Springfield, 07081 (US); ENRIGHT, Ryan, Floral Park, 11001 (US); BOLLE, Cristian, Bridgewater, 08807 (US); EARNSHAW, Mark, Berkeley Heights, 07922 (US)
(74) Representative: Nokia EPO representatives

(57) **Abstract**

Examples of the disclosure relate to apparatus for cooling components such as electronic circuitry components and photonic components. A first component and a second component are provided on the same surface of a substrate. At least one temperature control means, such as a thermoelectric cooler, is configured to control the temperature of at least one of the components. The apparatus also comprises a plurality of heat transfer means that extend through the substrate from the first surface to the second surface. The plurality of heat transfer means enable heat to be transferred from the components to a heat pipe provided on the second surface of the substrate. This enables heat to be transferred through the substrate and away from the components and so can reduce the amount of heat that spreads laterally across the substrate. This allows for efficient removal of heat from the components and reduces heat transfer between the components.

## Description

### TECHNOLOGICAL FIELD

Examples of the disclosure relate to apparatus for cooling components. Some relate to apparatus for cooling components such as electronic circuitry components and photonic components that could be used within consumer electronic devices.

### BACKGROUND

Components such as electronic circuitry components and photonic components can generate unwanted heat during use. In many cases the photonic components will generate less heat than electronic components but the photonic components might be more temperature sensitive and stable operating temperatures may improve the efficiency of operation of such devices. This needs to be taken into account when packaging such components for use in devices such as consumer electronic devices.

### BRIEF SUMMARY

According to various, but not necessarily all, examples of the disclosure there is provided an apparatus comprising:
a substrate comprising a first surface and a second surface;
at least a first component and a second component each mounted on the first surface of the substrate;
a plurality of heat transfer means extending through the substrate from the first surface to the second surface;
at least part of a heat pipe provided on the second surface of the substrate and thermally connected to the plurality of heat transfer means; and
at least one temperature control means configured to control temperature of at least one of the components.

The at least one temperature control means may comprise at least one thermoelectric cooler and/or at least one or more heater within the second component.

The thermoelectric cooler may be mounted on the first surface of the substrate.

The thermoelectric cooler may be mounted within a cavity of the substrate.

The thermoelectric cooler may be configured to reject heat into the at least one heat pipe.

The plurality of heat transfer means may comprise thermal vias.

The plurality of heat transfer means may comprise portions of the at least one heat pipe embedded within the substrate.

The at least one heat pipe may comprise at least a first heat pipe and a second heat pipe where the first heat pipe is provided on the second surface of the substrate and thermally connected to the plurality of heat transfer means and the second heat pipe is provided on the first surface of the substrate and thermally connected to at least one of the at least one electronic circuitry component or the at least one photonic component.

The at least one heat pipe may comprise at least one oscillating heat pipe.

The oscillating heat pipe may comprise two or more evaporator portions.

The apparatus may be configured so that the at least one electronic circuitry component rejects heat into an evaporator portion of the oscillating heat pipe and the at least one photonic component rejects heat into a second evaporator portion of the oscillating heat pipe.

The oscillating heat pipe may comprise a plurality of different working fluids.

The apparatus may comprise one or more electrical connections between the at least one electronic circuitry component and at least one photonic component wherein the one or more electrical connections are provided on the substrate.

The substrate may be a thermally insulating substrate.

The first component may comprise an electronic circuitry component and the second component comprises a photonic component.

According to various, but not necessarily all, examples of the disclosure there may be provided an electronic device comprising one or more apparatus as claimed in any preceding claim.

According to various, but not necessarily all, examples of the disclosure there is provided an apparatus comprising:
a substrate comprising a first surface and a second surface;
at least a first component and a second component each mounted on the first surface of the substrate;
at least one heat pipe provided, at least partially, on the second surface of the substrate; and wherein
the at least one heat pipe comprises a plurality of portions that extend through the substrate to provide heat transfer means from the first surface to the portions of the heat pipe on the second surface.

According to various, but not necessarily all, examples of the disclosure there is provided an apparatus comprising:
a substrate comprising a first surface and a second surface;
at least a first component and a second component each mounted on the first surface of the substrate;
a plurality of heat transfer means extending through the substrate from the first surface to the second surface; and
at least one oscillating heat pipe provided on the second surface of the substrate and thermally connected to the plurality of heat transfer means.

### BRIEF DESCRIPTION

Some examples will now be described with reference to the accompanying drawings in which:
FIG. 1 shows an example apparatus;
FIG. 2 shows an example apparatus;
FIG. 3 shows an example apparatus;
FIG. 4 shows an example apparatus;
FIG. 5 shows an example apparatus;
FIG. 6 shows an example oscillating heat pipe;
FIGS. 7A to 7D show a first set of results for an example apparatus; and
FIGS. 8A to 8F show a second set of results for an example apparatus.

### DETAILED DESCRIPTION

Examples of the disclosure relate to apparatus for cooling components such as electronic circuitry components and photonic components. In examples of the disclosure at least a first component and a second component are provided on the same surface of a substrate. The apparatus comprises at least one temperature control means, such as a thermoelectric cooler, that are configured to control the temperature of at least one of the components. The apparatus also comprises a plurality of heat transfer means that extend through the substrate from the first surface to the second surface. The plurality of heat transfer means enable heat to be transferred from the components to a heat pipe provided on the second surface of the substrate. This enables heat to be transferred through the substrate and away from the components and so can reduce the amount of heat that spreads laterally across the substrate. This allows for efficient removal of heat from the components and reduces heat transfer between the components.

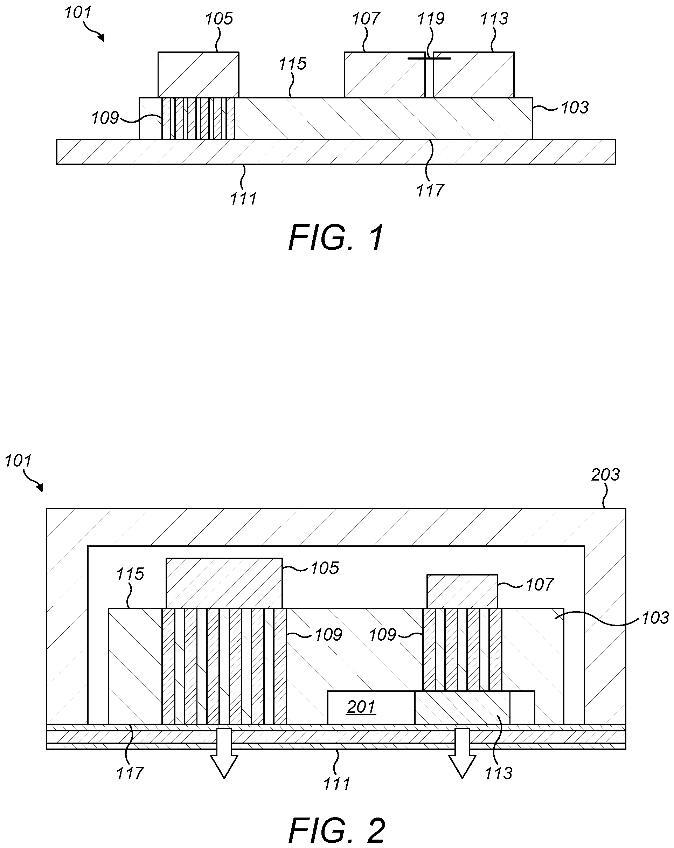

Fig. 1 schematically shows an apparatus 101 according to examples of the disclosure. The parts of the apparatus 101 are not shown to scale.

The apparatus 101 can comprise optoelectronic components that can be provided inside an electronic device such as a smartphone, tablet, computer or other suitable electronic device such as a consumer electronic device. In the example of Fig. 1 the apparatus 101 comprises a substrate 103, a first component 105, a second component 107, a plurality of heat transfer means 109, at least one heat pipe 111 and at least one temperature control means 113. It is to be appreciated that the apparatus 101 could comprise other components in other examples of the disclosure.

The substrate 103 comprises a first surface 115 and a second surface 117. The second surface 117 is on an opposing side of the substrate 103 to the first surface 115.

In the example of Fig. 1 the substrate 103 is flat or substantially flat, so that both the first surface 115 and the second surface 117 are flat or substantially flat. Other shapes of the substrate 103 could be used in other examples of the disclosure.

The substrate 103 can be thermally insulating so that significantly less heat is transferred through the substrate 103 than is transferred through the heat transfer means 109. The substrate 103 can comprise glass or any other suitable material. In some examples the substrate can have a low thermal conductivity. The low thermal conductivity could be about 1 W/m/K or lower than 1 W/m/K.

A first component 105 and a second component 107 are mounted on the first surface 115 of the substrate 103. Each of the first component 105 and the second component 107 can comprise photonic components and/or any other suitable component that can be used within an electronic device. One or both components 105 and 107 generate unwanted heat during use.

The substrate 103 is configured so that a plurality of heat transfer means 109 extend through the substrate from the first surface to the second surface. The heat transfer means 109 can comprise any means or systems that can be configured to remove heat from one or more of the components 105, 107 and transfer it to one or more heat pipes 111. In some examples, the heat transfer means 109 can comprise any means or systems that can be configured to remove heat from one or more of the components 105, 107 and transfer it to the other side of the substrate 103.

In some examples the heat transfer means 109 can comprise a plurality of thermal vias. The thermal vias can be formed from a thermally conductive material. The thermal vias can comprise copper or any other suitable material with a larger thermal conductivity than the one of the substrate 103. The thermal vias can extend through the substrate 103 in a direction that is perpendicular, or substantially perpendicular to the first surface 115, and the second surface 117.

In some examples the heat transfer means 109 can comprise a portion of one or more heat pipes 111 that can be configured to extend through the substrate. For example, the heat pipe 111 could comprise a bend so that a portion of the heat pipe 111 extends along the second surface 117 of the substrate 103 and while other portions extend through the substrate 103.

The apparatus 101 also comprises at least one heat pipe 111 provided on the second surface 117 of the substrate 103 and thermally connected to the plurality of heat transfer means 109. The heat pipe 111 can comprises a two-phase cooling system or any other suitable cooling system. In some examples the heat pipe 111 can comprise an oscillating heat pipe. Only a section of the heat pipe 111 is shown in Fig. 1.

The heat pipe 111 can be formed from a material with a high thermal conductivity such as silicon, ceramics or aluminium. In other examples the heat pipe 111 could be formed from a material with a low thermal conductivity such as glass. In such examples the glass heat pipe 111 could be configured to transfer the heat laterally within the substrate 103.

The heat pipe 111 is thermally connected to the heat transfer means 109 so as to enable heat from the heat transfer means 109 to be rejected into the heat pipe 111. The heat pipe 111 can then transfer the heat away from the apparatus 101 and the components 105, 107 within the apparatus 101. The heat pipe 111 can be configured to transfer heat away from the apparatus 101 to another part of the electronic device that comprises the apparatus 101.

The heat pipe 111 can comprise at least one evaporator portion positioned close to the first component 105 and/or the second component 107. Heat from the first component 105 and/or the second component 107 can be rejected into the heat pipe 111 in the evaporator regions. The heat pipe 111 also comprises one or more condenser regions. The condenser regions can be positioned remote to the apparatus 101. The condenser regions can be positioned close to a heat sink or any other means that enables heat to be transferred out of the heat pipe 111.

The apparatus 101 also comprises a temperature control means 113 configured to control temperature of the at least one of the components 105, 107. In the example of Fig. 1 the temperature control means 113 is configured to control the temperature of the second component 107. A heat transfer path 119 can be provided between the second component 107 and the temperature control means 113. Whether the temperature control means 113 is configured to control the temperature of the first component 105 and/or the second component 107 can depend upon what type of components they are. For example, some components, such as photonics components have narrow temperature operating ranges which can therefore require temperature control means 113. Other components such as processors or drivers might generate a lot of heat but can still operate efficiently at higher temperatures and so the temperature control means 113 might not be needed for such components.

The temperature control means 113 can be configured to maintain the second component 107 at a stable temperature. The temperature control means 113 can be configured to maintain the second component 107 within a stable temperature range. The temperature control means 113 can be configured to cool the second component 107 if the temperature of the second component 107 is above a threshold value and can be configured to heat the second component 107 if the temperature of the second component 107 is below a threshold value.

In some examples the temperature control means 113 can comprise at least one thermoelectric cooler, an electric heater and/or any other suitable means. In some examples the temperature control means 113 can comprise one or more heaters integrated with the component 107. The thermoelectric cooler can be provided in any suitable location within the apparatus 101. In some examples the thermoelectric cooler can be positioned so as to minimise, or substantially minimise, the thermal resistance between the thermoelectric cooler and the second component 107. In some examples the thermoelectric cooler can be mounted on the first surface 115 of the substrate 103. In other examples the thermoelectric cooler can be mounted within a cavity of the substrate 103 and/or provided on a second surface 117 of the substrate 103.

In some examples, temperature control means 113 could comprise one or more heaters that could be integrated, or otherwise provided, within the second component.

In some examples the temperature control means 113 can be configured to reject heat into a heat pipe 111. In some examples both the temperature control means 113 and the heat transfer means 109 can transfer heat into the same heat pipe 111. In other examples the heat transfer means 109 can transfer heat into a first heat pipe 111 and the temperature control means 113 can transfer heat into a second different, heat pipe.

The apparatus 101 as shown in Fig. 1 allows heat from the first component 105 to be transferred from the heat transfer means 109 and into the heat pipe 111. The heat pipe 111 then transfers the heat away from the apparatus 101. The heat transfer means 109 therefore directs the heat through the substrate 103. This reduces the amount of heat that is transferred laterally across the surface and reduces cross talk between the first component 105 and the second component 107.

As the amount of heat transferred between the components 105, 107 is reduced this can allow the components 105, 107 to be positioned close together. This can enable short and efficient electrical connections to be used between the first component 105 and the second component 107. The electrical connections could be high speed transmission lines, metal transmission lines provided on the first surface 115 of the substate 103 and/or any other suitable electrical connections.

Examples of the disclosure can also significantly reduce the power required by the temperature control means 113. This can be useful in devices where the temperature control means 113 comprises a thermoelectric cooler because such means require a lot of power and can place large demands on the battery or other power source of a device.

The respective components of the apparatus 101 can be provided in any suitable configurations. Various example configurations of the apparatus 101 are shown in Figs. 2 to 5. It is to be appreciated that other configurations could also be used in implementations of the disclosure.

Fig. 2 schematically shows an apparatus 101 according to examples of the disclosure. The example apparatus 101 of Fig. 2 comprises a substrate 103, a first component 105, a second component 107, a plurality of heat transfer means 109, a heat pipe 111 and a temperature control means 113. These are provided within an encapsulation layer 203 to provide an apparatus 101 that can be used within electronic devices such as mobile phones or other suitable devices.

In the example of Fig. 2 the substrate 103 is an interposer. The substrate 103 comprises glass. Glass can be suitable for use because it provides excellent radio frequency properties for high-speed electrical propagation. This can be useful for transferring signals between components 105, 107 on the substrate 103.

Glass can also be machined to implement features such as heat transfer means 109 or thermal vias that increase electrical integration density and can have appropriate coefficient of thermal expansion values for reliable assembly of optoelectronic devices.

Other materials could be used for the substrate 103 in other examples of the disclosure.

In the example of Fig. 2 the first component 105 comprises an electronic circuitry component 105 and the second component 107 comprises a photonic component 107. Other types of components could be used in other examples of the disclosure.

The electronic circuitry component 105 and photonic component 107 can comprise any suitable combination of components. For instance, in some examples the electronic circuitry component 105 could comprise a driver and the photonic component could comprise a laser, a modulator or a semiconductor amplifier or combination of those components and/or arrays of those components. In some examples the electronic circuitry component 105 could comprise an amplifier, such as a transimpedance amplifier or an amplifier array and the photonic component 107 could comprise a photodetector or a photodetector array. The electronic circuitry component 105 and the photonic component 107 could comprise a LIDAR system or any other suitable type of system.

The electronic circuitry component 105 comprises electronic circuitry mounted on the first surface of the substrate 103. The electronic circuitry component 105 can comprise a chip or any other suitable component. In some examples the electronic circuitry component 105 can comprise one or more controllers or drivers that can be configured to control or drive the photonics component 107. In some examples the electronic circuitry component 105 could also be configured to provide control signals to and/or to receive control signals from other components within an electronic device. The electronic circuitry can be configured to receive signals from the photonics component 107. These signals could be used to enable the electronic circuitry component 105 to control or drive the photonics component 107.

The photonic component 107 comprises one or more optical circuits mounted on the surface of the substrate 103. The photonic component 107 can comprise a chip or any other suitable component. The optical circuits can be configured to provide light sources or other optical signals. The photonic components 107 can be configured for use in LiDAR applications, mediated reality, bio-sensing, health monitoring, optical communications or for any other suitable purpose.

Both the first component 105 and the second component 107 are provided on a first surface 115 of the substrate 103.

The substrate 103 comprises a plurality of heat transfer means 109 that extend through the substrate 103. The heat transfer means 109 extend from the first surface 115 of the substrate 103 the second surface 117 of the substrate 103.

The heat transfer means 109 can be provided underneath the footprint area of the components 105, 107. The heat transfer means 109 can be provided in a high density underneath the components 105, 107. The high density can provide for a large number of heat transfer means 109 within a given area underneath the components 105, 107. The high density of the heat transfer means 109 can enable efficient transfer of heat away from the components 105, 107. The density of the heat transfer means underneath the components 105, 107 can be high compared to one or more lower density areas which can be outside of the footprints of the components 105, 107.

In this example the heat transfer means 109 comprise thermal vias. The thermal vias can comprise a thermally conductive material such as copper. The thermal vias extend between the surfaces 115, 117 of the substate 103, and may extend perpendicularly, or substantially perpendicularly to the surfaces 115, 117 of the substrate 103.

In the example of Fig. 2 the heat transfer means 109 are provided underneath both the first component 105 and the second component 107. The heat transfer means 109 are configured to transfer heat away from both the first component 105 and the second component 107. This reduces heat being transferred from the first component 105 to the second component 107 and also reduces heat being transferred from the second component 107 to the first component 105. Other arrangements of the heat transfer means 109 could be used in other examples of the disclosure. For example, the heat transfer means 109 could be provided underneath just one of the components 105, 107.

In the example of Fig. 2 the temperature control means 113 are configured to control the temperature of the second component 107. In this example the temperature control means 113 comprises a thermoelectric cooler. Other types of temperature control means 113 could be used in other examples of the disclosure.

In the example of Fig. 2 the temperature control means 113 is provided within a cavity 201 of the substrate 103. The cavity 201 is etched into the second surface 117 of the substrate 103 so that the temperature control means 113 is provided on an opposite side of the substrate 103 to the second component 107. As the temperature control means 113 is provided on an opposite side of the substrate 103 to the second component 107 heat transfer means 109 are provided extending through the substrate 103 between the second component 107 and the temperature control means 113. These heat transfer means 109 can be configured to enable unwanted heat to be transferred from the second component 107 to the temperature control means 113 if the temperature of the second component 107 is above a threshold temperature. The heat transfer means 109 can also enable heat to be transferred from the temperature control means 113 to the second component 107 if the temperature of the second component 107 is below a threshold temperature.

The apparatus 101 in Fig. 2 comprises a single heat pipe 111. This heat pipe 111 is provided on the second surface 117 of the substrate 103. The heat pipe 111 is thermally coupled to the heat transfer means 109 that reject heat from the first component 105. This enables unwanted heat from the first component to be rejected into the heat pipe 111. The heat pipe 111 is also thermally connected to the temperature control means 113. This enables heat from the temperature control means 113 to be rejected into the heat pipe 111.

In the example of Fig. 2 the same heat pipe 111 is thermally connected to both the heat transfer means 109 and the temperature control means 113. In other examples the apparatus 101 could comprise a plurality of heat pipes 111 so that a first heat pipe could be connected to the heat transfer means 109 that reject heat from the first component 105 and a second heat pipe could be connected to the temperature control means 113.

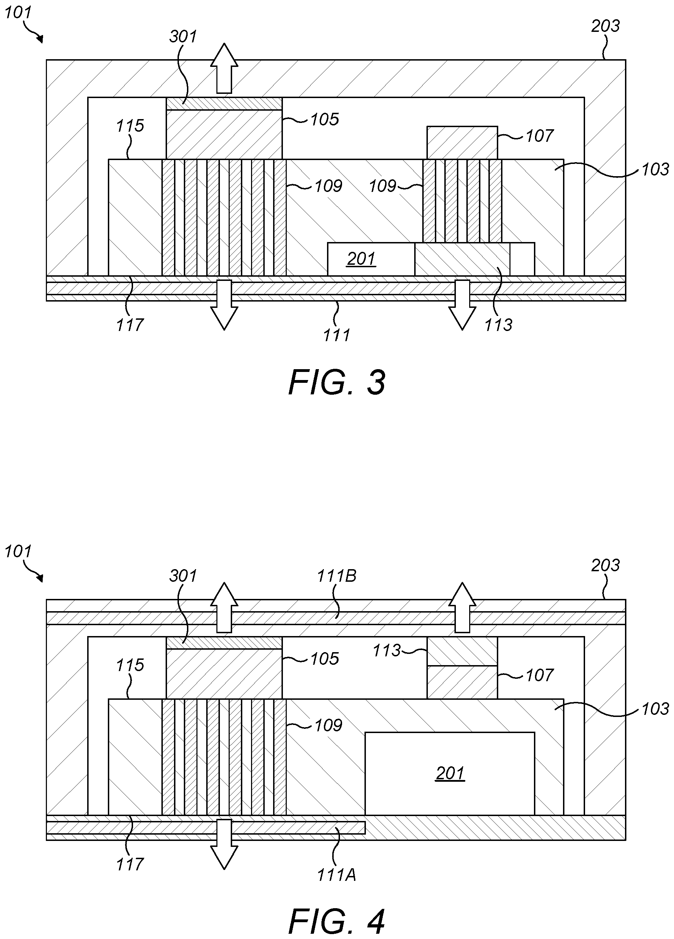

Fig. 3 schematically shows another apparatus 101 according to examples of the disclosure. The example apparatus 101 of Fig. 3 comprises a substrate 103, a first component 105, a second component 107, a plurality of heat transfer means 109, a first heat pipe 111 and a temperature control means 113 that are provided within an encapsulation layer 203. These are all arranged in the same way as shown in Fig. 2.

In Fig. 3 an additional thermal interface material 301 is provided on the first component 105. The thermal interface material 301 is positioned between the first component 105 and the encapsulation layer 203. The thermal interface material 301 is thermally connected to the first component 105 and is configured to enable heat to be transferred from the first component 105 into the encapsulation layer 203. The thermal interface material 301 can be provided in a thin layer so as to optimize, or substantially optimize, heat transfer from the first component 105 into the encapsulation layer 203. The thermal interface material 301 could comprise gap pads, putty pads, hybrid or any other suitable thermal interface material.

The use of the thermal interface material 301 in Fig. 3 enables heat to be rejected from the first component 105 in two different directions. In the example of Fig. 3 the heat is rejected in two opposing, or substantially, opposing directions. The thermal interface material 301 enables heat to be transferred out of the first component 105 in an upwards direction. The heat transfer means 109 enables heat to be transferred out of the first component 105 in a downwards direction. Both the heat transfer means 109 and the thermal interface material 301 reduce the heat that flows laterally across the substrate 103 to the second component 107 or any other components on the substrate 103.

Fig. 4 schematically shows another apparatus 101 according to examples of the disclosure. The example apparatus 101 of Fig. 4 also comprises a substrate 103, a first component 105, a second component 107, a plurality of heat transfer means 109, two heat pipes 111 and a temperature control means 113 that are provided within an encapsulation layer 203.

In the example of Fig. 4 the apparatus 101 comprises two heat pipes 111A, 111B. The first heat pipe 111A is provided on the second surface 117 of the substrate 103 and thermally connected to the heat transfer means 109 that extend through the substrate 103. In the example of Fig. 4 the heat transfer means 109 are only provided underneath the first component 105. There are no heat transfer means 109 provided underneath the second component 107. In this example the first heat pipe 111A is only provided underneath the first component 105 and the heat transfer means 109 that are configured to remove the heat from the first component 105.

The second heat pipe 111B is provided in the encapsulation layer 203 above the components 105, 107. A layer of thermal interface material 301 is positioned between the first component 105 and the second heat pipe 111B. This enables heat from the first component 105 to be rejected into the second heat pipe 111B.

The temperature control means 113 is provided overlaying the second component 107. In this example the temperature control means 113 is stacked over the second component 107. This can ensure that good thermal contact is maintained between the second component 107 and the temperature control means 113.

The temperature control means 113 is also thermally connected to the second heat pipe 111B, for example via a thermal interface material, so that unwanted heat from the second component 107 can be rejected into the second heat pipe 111B.

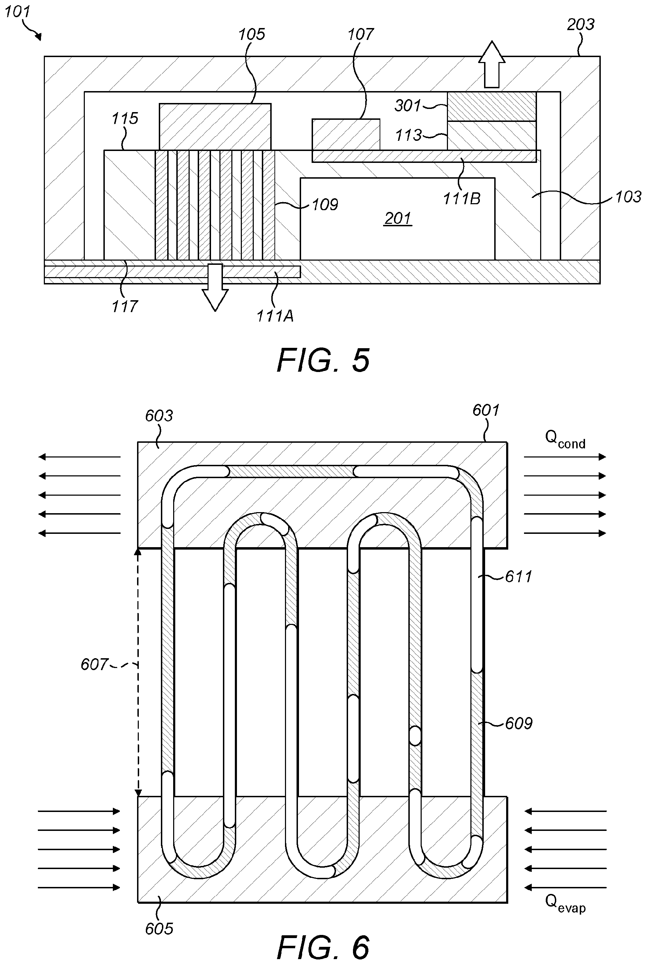

Fig. 5 schematically shows another apparatus 101 according to examples of the disclosure. The example apparatus 101 of Fig. 5 also comprises a substrate 103, a first component 105, a second component 107, a plurality of heat transfer means 109, two heat pipes 111 and a temperature control means 113 that are provided within an encapsulation layer 203.

In the example of Fig. 5 the temperature control means 113 is mounted on the first surface 115 of the substrate 103. The temperature control means 113 is positioned adjacent to the second component 107 on the first surface 115 of the substrate 103. The temperature control means 113 is thermally connected to the second component 107 so that unwanted heat from the second component 107 can be rejected to the temperature control means 113. The thermal connection between the second component 107 and the temperature control means 113 can also enable the temperature control means 113 to heat the second component 107 if the temperature of the second component drops below a threshold.

The example apparatus 101 of Fig. 5 comprises a first heat pipe 111A that is provided on the second surface 117 of the substrate 103 and a second heat pipe 111B that is provided on the first surface 115 of the substrate 103.

The first heat pipe 111A is thermally connected to the heat transfer means 109 that extend through the substrate 103. In the example of Fig. 5 the heat transfer means 109 are only provided underneath the first component 105. There are no heat transfer means 109 provided underneath the second component 107. In this example the first heat pipe 111A is only provided underneath the first component 105 and the heat transfer means 109 that are configured to remove the heat from the first component 105.

The second heat pipe 111B is provided at the first surface 115 of the substrate 103. The second heat pipe 111B could be embedded at the first surface 115 of the substrate 103. The second heat pipe 111B thermally connects the second component 107 to the temperature control means 113.

The example apparatus 101 of Fig. 5 also comprises a layer of thermal interface material 301 on the temperature control means 113. The thermal interface material 301 is thermally connected to the temperature control means 113 and is configured to enable heat to be transferred from the temperature control means 113 into the encapsulation layer 203. The thickness of the thermal interface material 113 can be determined by the size of the spacing between the temperature control means 113 and the encapsulation layer 203.

Variations to the examples described above could be used in other implementations of the disclosure. For instance, in some examples the first heat pipe 111A is provided partially on the second surface 117 of the substrate 103 and has some portions that extend through the substrate 103. The portions of the first heat pipe 111A that extend through the substrate 103 can provide heat transfer means 109 through the substrate 103.

In some examples the heat pipe 111 can comprise a plurality of evaporator portions. The different evaporator portions can be positioned so that heat from a first component 105 is rejected into a first evaporator portion and heat from a second component 107 is rejected into a second, different evaporator portion.

Any suitable working fluid can be used within the heat pipe 111. In some examples fluorinated working fluids such as R1233zd(E) could be used. These fluids have low global warming potential (GWP) but provide suitable surface tension, latent heat and liquid-to-vapor density difference values for use in heat pipes 111.

In some examples the heat pipe 111 can comprise a single working fluid. In other examples the heat pipe 111 can comprise a plurality of different working fluids. The different working fluids can be selected to optimize, or substantially optimize, heat transfer from the different components 105, 107 into the heat pipe 111.

Fig. 6 shows an example oscillating heat pipe 601 that could be used as a heat pipe 111 in some examples of the disclosure. The oscillating heat pipe 601 comprises a condenser region 603, an evaporator region 605 and an adiabatic section 607.

The evaporator region 605 comprises any means for transferring heat from a heat source into the working fluid within the oscillating heat pipe 601. The evaporator region 605 is thermally coupled to a heat source, for example via a thermal interface material. The heat source could be the components such as an electronic circuitry component 105 or a photonic component 107. The oscillating heat pipe 601 could be machined into the outer surfaces of the substrate 103.

The condenser region 603 comprises any means for transferring heat out of the working fluid within the oscillating heat pipe 601. The condenser region 603 is thermally coupled to a heat sink or any other suitable type of means for transferring heat out of the working fluid.

The oscillating heat pipe 601 is configured in a meandering or serpentine configuration comprising a plurality of bends. A first plurality of bends is located in the evaporator region 605 and a second plurality of bends is located in the condenser region 603. In the example shown in Fig. 6 three U-shaped bends are shown in the evaporator region 605 and two U-shaped bends are shown in the condenser region 603. Other configurations and numbers of bends could be used in other examples of the disclosure. The meandering or serpentine configuration is configured so that the working fluid within the oscillating heat pipe 601 is alternately heated in the evaporator region 605 and cooled in the condenser region 603 of the oscillating heat pipe 601.

In the example shown in Fig. 6 the oscillating heat pipe 601 forms a closed loop. Other types of oscillating heat pipe 601 could be used in other examples of the disclosure. For instance, the oscillating heat pipe could be an open loop oscillating heat pipe configured without connecting ends in the condenser region 603. The oscillating heat pipe could comprise a valve or a microvalve configured to allow for charging and discharging of working fluid.

In the example shown in Fig. 6 an adiabatic section 607 is provided between the evaporator region 605 and the condenser region 603. The adiabatic section 607 extends between the bends in the condenser region 603 and the bends in the evaporator region 605. The adiabatic section 607 ensures that heat that is transferred into the working fluid in the evaporator region 605 is retained within the oscillating heat pipe 601 until the working fluid reaches the condenser region 603. In some examples the oscillating heat pipe 601 does not comprise an adiabatic section 607. Whether or not the oscillating heat pipe 601 comprises an adiabatic section 607 can depend on the application and system geometry of the oscillating heat pipe 601 and any other suitable factors.

The oscillating heat pipe can be designed so that the footprints areas of the evaporator regions 605 and the condenser region 603 are dependent on the type of components 105, 107 and the type of heat sink.

When the oscillating heat pipe 601 is in use, heat is applied to the working fluid in the bends within the evaporator region 605. This heat causes, at least some of, the working fluid to evaporate. This evaporation results in an increase of vapour pressure inside the oscillating heat pipe 601 which causes the growth of bubbles within the evaporator region 605. The growth of the bubbles and the increase in vapour pressure forces liquid slugs 609 of the working fluid towards the condenser region 603. The working fluid that is pushed to the condenser region 603 is then cooled by the condenser. This cooling reduces the vapour pressure within the working fluid and causes condensation of the bubbles and provides a restoring force that pushes the working fluid back towards the evaporator region 605. This process of alternate bubble growth and condensation causes oscillation of the working fluid within the oscillating heat pipe 601 and allows for an efficient heat transfer between the evaporator region 605 and the condenser region 603.

The example oscillating heat pipe 601 in Fig. 6 comprises a single loop with a single evaporator region 605. In some examples the oscillating heat pipe 601 could comprise a plurality of loops. The different loops could comprise different evaporator regions 605 and could be configured to dissipate heat from different components 105, 107 or other heat sources. For example, a first loop could dissipate heat from the first component 105 while a second loop could dissipate heat from the second component 107 and/or the temperature control means 113. Having the plurality of loops can provide for design flexibility within the oscillating heat pipe 601. This can enable the number of bends and the geometry of the heat pipe to be optimized, or substantially optimized, for dissipating heat from the different components 105, 107.

In some examples the oscillating heat pipe 601 can comprise structures that are configured to accelerate the boiling of the working fluid. The structures could comprise fins, high density channels or other suitable structures. The structures can be positioned at specific locations within the oscillating heat pipe 601 so as to accelerate the boiling process, for example, the structures could be located where the oscillating heat pipe 601 is close to components that generate high levels of heat. The density of the channels within the oscillating heat pipe 601 can be decreased for regions where the oscillating heat pipe 601 dissipates heat from lower heat generating components.

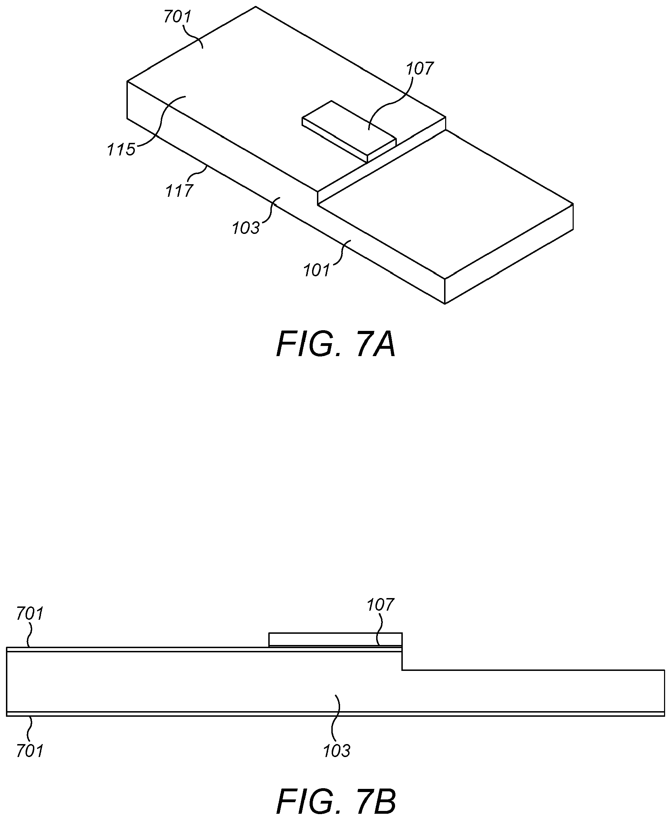

Figs. 7A to 7D show sections of an apparatus 101 and a set of results comparing the performance of an example apparatus 101 with an apparatus that uses conduction to remove heat from the components 105, 107.

Fig. 7A shows a perspective view of an example apparatus 101 that uses a conduction mechanism rather than heat pipes 111 to remove heat from the components 107. Fig. 7B shows a side view of the same apparatus 101.

In the example of Figs. 7A and 7B the apparatus 101 comprises a substrate 103. In this example the substrate 103 comprises silicon. Other materials could be used for the substrate 103 in other examples.

The apparatus 101 also comprises a second component 107 mounted on a first surface 115 of the substrate 103. In this example the second component 107 is a laser. The laser comprises a heat source. Other types of components could be used in other examples of the disclosure. The first component 105 is not shown for this simulation.

A thermally conductive layer 701 is provided on the first surface 115 of the substrate 103 and the second surface 117 of the substrate 103. In this example the thermally conductive layer 701 comprises gold.

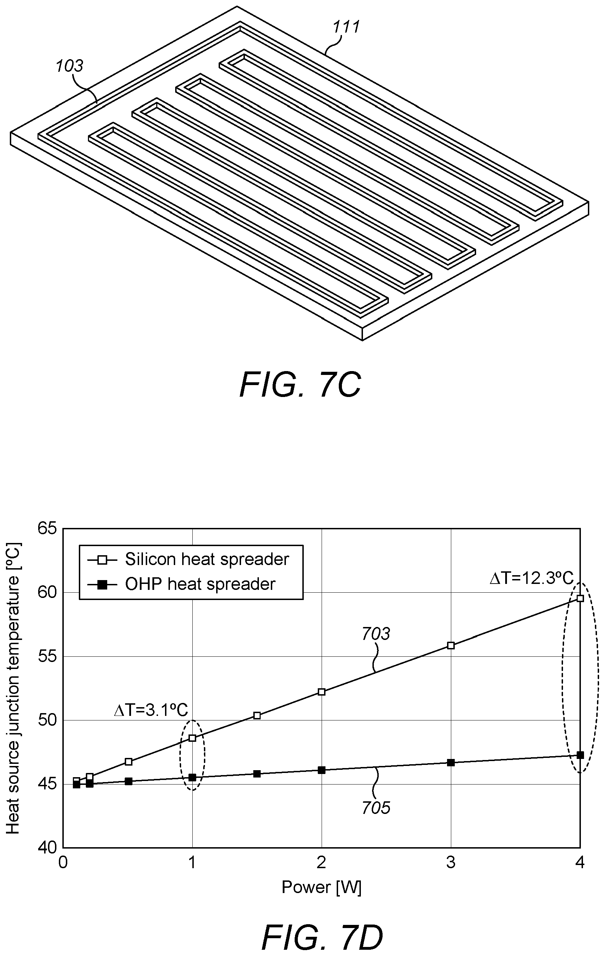

Fig. 7C shows an example heat pipe 111 that could be embedded within the substrate 103. In this example the heat pipe 111 is an oscillating heat pipe. The heat pipe 111 is flat or substantially flat heat pipe 111. The heat pipe 111 can be machined into the substrate 103.

Fig. 7D is a plot that shows the temperature of the second component 107 as a function of power. The first curve 703 shows the temperature for the apparatus 101 as shown in Fig. 7A and 7B where the thermally conductive surfaces 701 and the substrate 103 are used to remove the heat. The second curve 705 shows the temperature for the apparatus 101 with the embedded heat pipe 111. This shows that, at the maximum power of 4W the temperature difference between the two cases is about 12°C. This demonstrates a significant improvement in thermal management and heat removal capability. The use of the heat pipe 111 provides higher energy efficiency and better system scalability.

In order to obtain the results shown in Fig. 7D the following parameters were used.

The dimensions of the respective parts of the apparatus 101 were as given in the following table:

| **Part** | **Area** | **Height** |
|---|---|---|
| Laser | 0.5 mm x 1 mm | 0.1 mm |
| Heat Source | 0.5 mm x 1 mm | 1 µm |
| Silicon Interposer (section supporting laser) | 2 mm x 3 mm | 0.5mm |
| Silicon Interposer (section not supporting laser) | 2 mm x 2 mm | 0.32mm |
| Gold layer (top) | 2 mm x 3 mm | 1 µm |
| Gold layer (bottom) | 2 mm x 5 mm | 1 µm |
| Oscillating heat pipe | 2 mm x 5 mm | 0.3 mm |

The material used for the laser was indium phosphide.

The initial temperature of the apparatus 101 and the ambient air was 20°C.

The thermal conductivity of the materials within the apparatus 101 were defined as follows: copper k = 380 W/m/K, gold k = 317 W/m/K, indium phosphide k = 68 W/m/K, and silicon k = 130 W/m/K.

The heat source was modelled as a 1 µm thick layer of copper with heat generation between 0.1 - 4W.

The heat pipe 111 was embedded in the silicon substrate 103 and modelled with an equivalent thermal conductivity k of 800 W/m/K.

The boundary conditions used were that the side surfaces were adiabatic, the bottom surface had a uniform temperature of 45°C, the lateral surfaces of the heat source are adiabatic to maximize the input power and the lateral, front, back and top surface of the apparatus exchange heat with the environment with an effective-heat transfer coefficient of 36.4 W/m²/K.

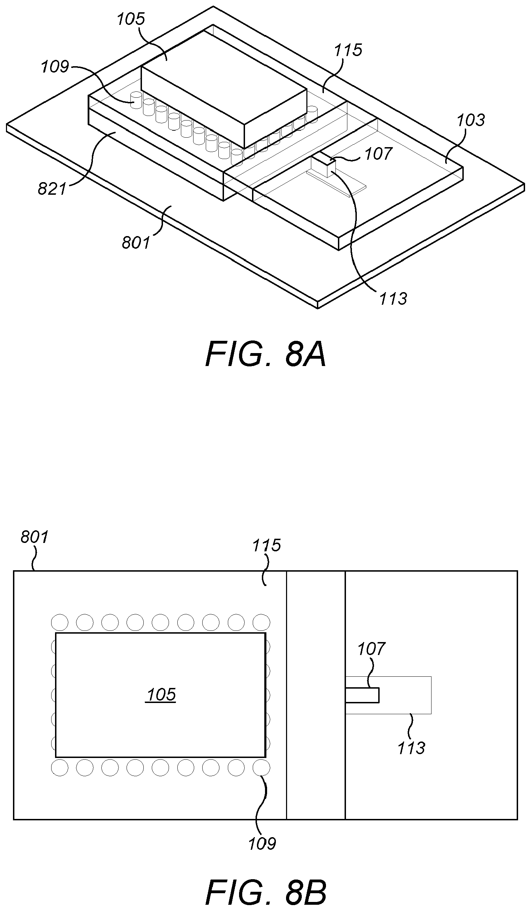

Figs. 8A to 8F show an apparatus 101 and a set of results comparing the performance of an example apparatus 101 comprising heat transfer means 109 that use air in forced convection to remove heat from the components 105, 107 against an apparatus 101 comprising heat transfer means 109 that uses air in natural convection to remove heat from the components 105, 107.

Figs. 8A and 8B show a perspective view of an example apparatus 101 and a plan view of an example apparatus 101. The apparatus 101 comprises a first component 105 and a second component 107. In this example the first component 105 is a driver for a laser and the second component 107 is the laser.

The first component 105 is mounted on a first surface of a substrate 103. In this example the substrate 103 comprises glass. A plurality of heat transfer means 109 are provided through the substrate 103. In this example the heat transfer means 109 comprise a plurality of copper thermal vias that extend through the substrate 103.

In this example the second component is also mounted on the first surface 115 of the substrate 103. The second component 107 is thermally coupled to a temperature control means 113. In this example the temperature control means 113 is a thermoelectric cooler. A plurality of heat transfer means 109 are provided through the substrate 103 underneath the second component 107. In this example the heat transfer means 109 underneath the second component 107 are smaller than the heat transfer means 109 underneath the first component 105. and so are not shown for clarity.

In this example the first component 105 is cooled using passive cooling via the heat sink 801 and the second component 107 is cooled using active cooling via a thermoelectric cooler. The thermoelectric cooler allows control of the operating temperature of the second component 107.

A heat sink 801 is provided underneath the substrate 103 and is configured to enable passive cooling of the first component 105. A heat spreader 821 is provided between the heat sink 801 and the substrate 103. The heat spreader 821 is provided underneath the section of the substrate 103 upon which the first component 105 is mounted.

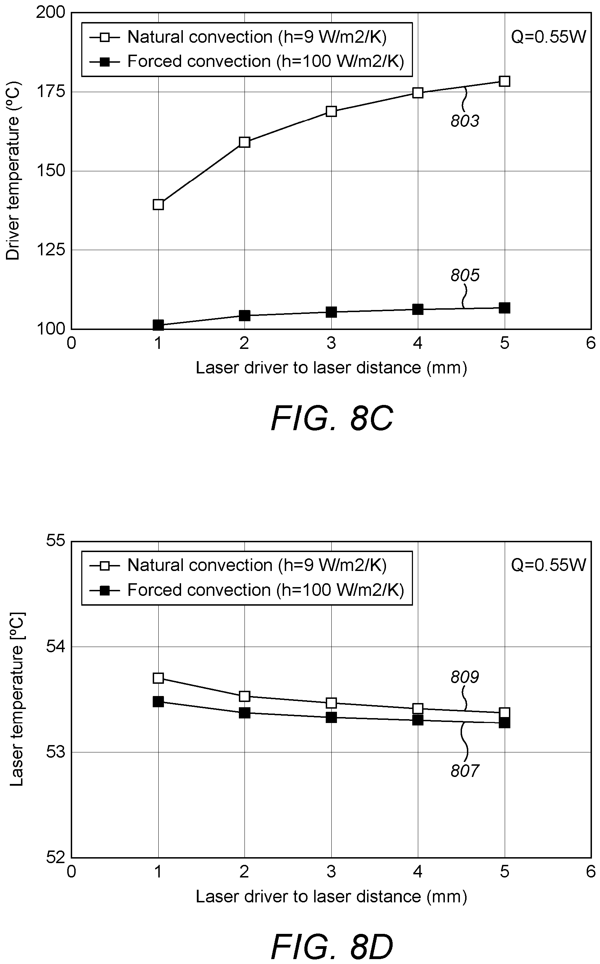

Figs. 8C to 8F show simulation results obtained with a total power of 0.55 W (driver power of 0.4 W and laser power of 0.15 W) plotted as a function of driver to laser distance varied from 1 mm to 5 mm.

Fig. 8C shows the average driver temperature. The first curve 803 shows the temperature for natural convection and the second curve 805 shows the temperature of the driver for forced convection. The natural or forced convection boundary conditions are applied at the bottom surface of the heat sink 801.

Curve 803 shows that the temperature of the driver increases with distance from the laser due to a larger surface area of the device being exposed to the ambient surroundings. In this example the ambient surroundings were assumed to be 85°C.

The use of the heat transfer means 109 coupled with air in forced convection improves the overall thermal performance of the apparatus 101. As shown by curve 805, the driver temperature can be reduced from 179°C to 107°C, when the distance between the driver and the laser is 5 mm.

As shown in Fig. 8D, the laser temperature is stable around 53°C in both of the apparatus 101 using forced convection and the apparatus 101 using natural convection. This is a result of good heat transfer between the heat transfer means 109 and the temperature control means 113 comprising a thermoelectric cooler cold side that is set to 50°C.

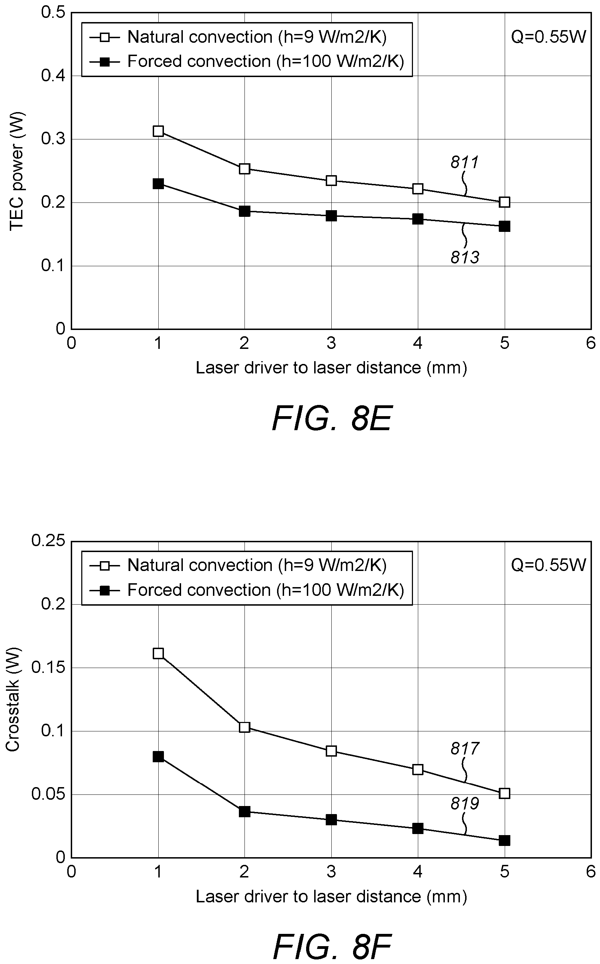

Fig. 8E shows the power of the temperature control means 113. The first curve 811 shows the power for natural convection and the second curve 813 shows the power for forced convention.

The power of the temperature control means 113 is calculated based on the laser power, plus the additional incoming heat flux from the driver to the laser when both components are in operation. A reduction in power of the temperature control means 113 is observed when forced convection is used because this results in less heat going from the driver to the laser.

Fig. 8F shows the cross talk between the driver and the laser as a function of the distance between the driver and the laser. In this case the cross talk is defined as the amount of parasitic heat flow from the driver to the temperature control means 113 when they are both mounted on the same substrate 103. The first curve 817 shows the cross talk for natural convection and the second curve 819 shows the cross talk for forced convention.

This plot shows that the cross talk decreases with the driver to laser distance. In this example the minimum value is 9% of the total laser power. The minimum cross talk is obtained for a distance between the laser and the driver equal to 5 mm in an apparatus 101 that uses forced convection.

In order to obtain the results shown in Figs. 8B to 8F the following parameters were used.

The dimensions of the laser driver 105 were 3 mm × 5 mm × 1mm. The heat transfer means 109 comprises 63 thermal vias each having a diameter of 0.4 mm and a pitch of 0.6 mm.

The dimensions of the laser 107 were 0.3 mm × 0.7 mm × 0.1 mm. The heat transfer means 109 comprises 45 thermal vias each having a diameter of 60 µm and a pitch of 90 µm.

The dimensions of the substrate 103 were 6 mm × 11-15 mm × 0.5 mm. The dimensions of the substrate 103 were variable to allow the distance between the laser and the laser driver to be varied between 1 mm and 5 mm.

A heat spreader was provided underneath the laser driver 105. This comprised aluminium and had the dimensions 6 mm × 6.5 mm × 0.7 mm.

The heat sink 801 comprised aluminium and had the dimensions 10 mm × 15 mm × 0.3 mm.

The temperature control means 113 has a footprint area, on the cold side, of 0.9 mm × 2.1 mm.

The thermal simulations were performed in steady state operation. The initial temperatures of the apparatus 101 and the ambient air were assumed to be 85°C.

The thermal conductivity of the materials within the apparatus 101 were, copper k = 380 W/m/K, gold k = 317 W/m/K, indium phosphide k = 68 W/m/K, glass k = 1.3 W/m/K.

The heat sources were the laser and the laser driver. These were modelled using volumetric heat generation corresponding to a total power for the laser driver of 0.4W and power for the laser of 0.15W.

The boundary conditions used were that the bottom surface of the temperature control means 113 was assumed to be 50°C. The heat sink 801 was assumed to reject heat with an air-side heat transfer coefficient of 9 W/m²/K for the case where natural convection was used and an air-side heat transfer coefficient of 100 W/m²/K for the case where forced convection was used. The temperature of the air was assumed to be 85°C.

In this description the term coupled can mean operationally coupled. Any number or combination of intervening elements can exist between coupled components, including no intervening elements.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning, then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. An apparatus comprising:
a substrate comprising a first surface and a second surface;
at least a first component and a second component each mounted on the first surface of the substrate;
a plurality of heat transfer means extending through the substrate from the first surface to the second surface;
at least part of a heat pipe provided on the second surface of the substrate and thermally connected to the plurality of heat transfer means; and
at least one temperature control means configured to control temperature of at least one of the components.

2. An apparatus as claimed in claim 1 wherein the at least one temperature control means comprises at least one thermoelectric cooler and/or at least one or more heater within the second component.

3. An apparatus as claimed in claim 2 wherein the thermoelectric cooler is mounted on the first surface of the substrate.

4. An apparatus as claimed in claim 2 wherein the thermoelectric cooler is mounted within a cavity of the substrate.

5. An apparatus as claimed in any of claims 2 to 4 wherein the thermoelectric cooler is configured to reject heat into the at least one heat pipe.

6. An apparatus as claimed in any preceding claim wherein the plurality of heat transfer means comprises thermal vias.

7. An apparatus as claimed in any preceding claim wherein the plurality of heat transfer means comprises portions of the at least one heat pipe embedded within the substrate.

8. An apparatus as claimed in any preceding claim wherein the at least one heat pipe comprises at least a first heat pipe and a second heat pipe where the first heat pipe is provided on the second surface of the substrate and thermally connected to the plurality of heat transfer means and the second heat pipe is provided on the first surface of the substrate and thermally connected to at least one of the at least one electronic circuitry component or the at least one photonic component.

9. An apparatus as claimed in any preceding clam wherein the at least one heat pipe comprises at least one oscillating heat pipe.

10. An apparatus as claimed in claim 9 wherein the oscillating heat pipe comprises two or more evaporator portions.

11. An apparatus as claimed in claim 10 wherein the apparatus is configured so that the at least one electronic circuitry component rejects heat into an evaporator portion of the oscillating heat pipe and the at least one photonic component rejects heat into a second evaporator portion of the oscillating heat pipe.

12. An apparatus as claimed in any of claims 9 to 11 wherein the oscillating heat pipe comprises a plurality of different working fluids.

13. An apparatus as claimed in any preceding claim comprising one or more electrical connections between the at least one electronic circuitry component and at least one photonic component wherein the one or more electrical connections are provided on the substrate.

14. An apparatus as claimed in any preceding claim, where the first component comprises an electronic circuitry component and the second component comprises a photonic component.

15. An electronic device comprising one or more apparatus as claimed in any preceding claim.
